# EUROPEAN PATENT APPLICATION

(11) **EP 4 322 072 A1**
(43) Date of publication of application: **14.02.2024**
(21) Application number: 23189805.7
(22) Date of filing: 04.08.2023
(51) Int. Cl.: G06N 10/40, G02B 6/293, H04Q 11/00

(54) **A METHOD FOR CONFIGURING A RECONFIGURABLE PHOTONIC INTEGRATED CIRCUIT**

(30) Priority: 05.08.2022 GB 202211473
(71) Applicant: QuiX Quantum BV, 7521 AN Enschede (NL)
(72) Inventor: DE GOEDE, Michiel, 7251 AN Enschede (NL); KASSENBERG, Benjamin Willem, 7521 AN Enschede (NL); SNIJDERS, Hendrik Joannes, 7521 AN Enschede (NL); TABALLIONE, Caterina, 7521 AN Enschede (NL); RENEMA, Jelmer Jan, 7521 AN Enschede (NL); VENDERBOSCH, Pim, 7521 AN Enschede (NL)
(74) Representative: CMS Cameron McKenna Nabarro Olswang LLP

(57) **Abstract**

A method of determining a first setpoint value for an adjustable parameter for each of a plurality of phase actuators in a reconfigurable photonic integrated circuit to cause is defined. The method comprises characterizing each phase actuator when all other phase actuators of the plurality of phase actuators are turned off and determining a first setpoint value for each phase actuator of the plurality of actuators based on the characterization. The method then comprises setting each phase actuator to its first setpoint value and iteratively adjusting the first setpoint value of at least some of the plurality of phase actuators to compensate for crosstalk.

## Description

The present disclosure relates to determining a setpoint value for an adjustable parameter for each of a plurality of phase actuators in a reconfigurable photonic integrated circuit wherein setting each of the plurality of phase actuators to its respective setpoint value causes the plurality of phase actuators to implement a first desired operation while compensating for crosstalk originating from phase actuators such as thermal, electrical, stress-optic, and electro-optic crosstalk between phase actuators and other known forms for crosstalk.

### BACKGROUND

A reconfigurable photonic integrated circuit is a network of interconnected light paths and phase actuators that can act on these light paths. The network of light paths and phase actuators implement a unitary operation on input light states wherein the operation being implemented can be controlled by adjusting the phase actuators. The operations performed by the reconfigurable photonic integrated circuit can be selected to, for example, route light in a photonic switch, reconfigure light states in a photonic network, or filter light signals by tunable filters (such as ring resonators). In addition, in some examples, the unitary operations can be unitary transforms that can be used to implement quantum computing operations, photonic machine learning or matrix multiplications that use classical light as input. While in some examples the unitary transforms used for quantum computing operations can be logical quantum gates such as the example X, Y, Z, H, S, T gate set (with the CNOT gate being possible to implement probabilistically), in other examples these unitaries can be unitary operations that encode all or part of a quantum algorithm without requiring the operation to be broken down into individual logical quantum gates.

A reconfigurable photonic integrated circuit is universally reconfigurable by implementing the appropriate phases on the phase actuators distributed throughout the network. This can be achieved by implementing a specific setting, such as a voltage, a current, a dissipated thermal power, or an applied stress on each actuator and hence inducing a corresponding phase on a specific light path. This phase-setting relationship is determined by characterizing the phase actuator. However, in a reconfigurable photonic integrated circuit phase actuators experience various forms of crosstalk from their distribution over the device and their mutual interconnections. This reduces the accuracy of the implemented unitary transform by the network on the input light fields and is detrimental for the reconfigurability of the photonic integrated circuit. In the context of large-scale networks, the accumulated errors from crosstalk can completely undermine the desired accuracy making implementation of unitaries in such networks infeasible.

It would be desirable to provide a method for configuring a reconfigurable photonic integrated circuit to implement a desired operation while considering crosstalk.

The examples described herein are not limited to examples which solve problems mentioned in this background section.

### SUMMARY

Examples of preferred aspects and embodiments of the invention are as set out in the accompanying independent and dependent claims.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

In first example of the disclosed technology a method of determining a first setpoint value for an adjustable parameter for each of a plurality of phase actuators in a reconfigurable photonic integrated circuit is disclosed. Setting each of the plurality of phase actuators to its respective first setpoint value causes the plurality of phase actuators to implement a first desired operation. The method comprises determining a first target phase for each phase actuator of the plurality of phase actuators such that when each phase actuator is set to its respective first target phase, the reconfigurable photonic integrated circuit implements the first desired operation. The method also comprises characterizing each phase actuator when all other phase actuators of the plurality of phase actuators are turned off to obtain a characterization for each phase actuator wherein the characterization for each phase actuator comprises a relationship between the phase and the adjustable parameter for the phase actuator. The method further comprises determining a first setpoint value for each phase actuator of the plurality of actuators based on the characterization of the phase actuator and the first target phase for the phase actuator and setting each phase actuator to its first setpoint value. The method comprises adjusting the first setpoint value of at least some of the plurality of phase actuators to compensate for crosstalk by iteratively: for each phase actuator of the at least some of the plurality of phase actuators: recharacterizing the phase actuator when all other phase actuators of the plurality of phase actuators are set to their respective first setpoint values to obtain a revised characterization comprising a revised relationship between the phase and the adjustable parameter for the phase actuator; determining a revised first setpoint value for the phase actuator based on the revised characterization and the first target phase for the phase actuator; and setting the phase actuator to have the revised first setpoint value as its first setpoint value; and after setting the at least some of the plurality of phase actuators to have a revised first setpoint value as their first setpoint value, determining an accuracy to which the plurality of phase actuators implement the first desired operation; comparing the accuracy to a threshold; in response to the accuracy not meeting the threshold repeating an iteration of adjusting the first setpoint value for at least some of the phase actuators; and in response to the accuracy meeting a threshold storing the first setpoint values for each of the plurality of phase actuators in association with the first desired operation. The first desired operation can be a first desired unitary operation. Characterizing each phase actuator when all other phase actuators of the plurality of phase actuators are turned off can be considered a 0-characterization performed in the absence of crosstalk. Recharacterizing the phase actuators can comprise a characterization performed in the presence of crosstalk that compensates for crosstalk. The above method enables setpoint values that implemented a desired operation to be determined while compensating for crosstalk. The above method can be more efficient than other methods where crosstalk may be directly measured and then compensated for.

In some examples the above method further comprises implementing the desired operation by setting each of the plurality of phase actuators to its first setpoint value. The first desired operation can thus be implemented using the reconfigurable photonic circuit at a time desired by the user. By storing the setpoint values the user can determine the setpoint values before the reconfigurable photonic integrated circuit is used meaning the reconfigurable photonic integrated circuit does not need to be characterized while in use.

In some examples the method further comprises determining second setpoint values wherein setting each of the plurality of phase actuators to its respective second setpoint value causes the plurality of phase actuators to implement a second desired operation. To this end, the method may further comprise determining a second target phase for each phase actuator such that when each phase actuator is set to its respective second target phase, the reconfigurable photonic integrated circuit implements the second desired operation. The method may further comprise obtaining a second characterization for each phase actuator when all other phase actuators of the plurality of phase actuators are turned off wherein the second characterization for each phase actuator comprises a relationship between the phase and the adjustable parameter for the phase actuator. The method may also comprise determining a second setpoint value for each phase actuator of the plurality of actuators based on the second characterization of the phase actuator and the second target phase for the phase actuator and setting each phase actuator to its second setpoint value. The method may further comprise adjusting the second setpoint value of at least some of the plurality of phase actuators to compensate for crosstalk by iteratively: for each phase actuator of the at least some of the plurality of phase actuators: recharacterizing the phase actuator when all other phase actuators of the plurality of phase actuators are set to their respective second setpoint value to obtain a revised second characterization comprising a revised relationship between the phase and the adjustable parameter for the phase actuator; determining a revised second setpoint value for the phase actuator based on the revised second characterization and the second target phase for the phase actuator; and setting the phase actuator to have the revised second setpoint value as its second setpoint value; and after setting the at least some of the plurality of phase actuators to have a revised second setpoint value as their second setpoint value, determining an accuracy to which the plurality of phase actuators implement the second desired operation; comparing the accuracy to a threshold; in response to the accuracy not meeting a threshold repeating an iteration of adjusting the second setpoint value for at least some of the phase actuators; and in response to the accuracy meeting a threshold storing the second setpoint value for each of the plurality of phase actuators in association with the second desired operation. The second desired operation may be a second desired unitary operation. In some examples the second characterization may comprise the first/original 0-characterization and may be obtained from the first/original 0-characterization being stored and retrieving this first/original characterization when required. Crosstalk may change with the setpoint values of the phase actuators. Hence, repeating the process of characterizing the phase actuators in the presence of crosstalk enables multiple different desired operations to be performed while compensating for crosstalk.

In some examples the method further comprises determining whether the first desired operation and the second desired operation differ by more than a threshold amount. Responsive to determining the first desired operation and the second desired operation differ by more than a threshold amount a second characterization different from the first characterization may be obtained as described above in order to obtain the second setpoint values for the phase actuators. However, responsive to determining the first desired operation and the second desired operation do not differ by more than a threshold amount, the method may comprise using the revised characterizations of each phase actuator to obtain the second setpoint values for the phase actuators. If the setpoint values for the phase actuators do not differ by much between desired operations then it may be possible to use an original/first characterization found for a first desired operation in the presence of crosstalk to obtain setpoints for a second desired operation. This reduces the amount of work involved in obtaining setpoint values for several desired operations particularly when the desired operations are similar.

In some examples the method further comprises using the reconfigurable photonic integrated circuit to selectively implement the first and second desired operation by: setting each of the plurality of phase actuators to its first setpoint value to implement the first desired operation; and setting each of the plurality of phase actuators to its second setpoint value to implement the second desired operation. This enables the reconfigurable photonic integrated circuit to be reconfigured in use to implement multiple desired operations. The determining of setpoint values can be done before use of the reconfigurable photonic integrated circuit meaning this does not need to be done while the photonic integrated circuit is in use increasing the practicality of using the photonic integrated circuit.

In some examples, determining an accuracy to which the plurality of phase actuators implement the first desired operation comprises determining a difference between the first setpoint values to which the plurality of phase actuators were set at the start of the iteration and the revised first setpoint values to which the plurality of phase actuators are set at the end of an iteration. In these examples, comparing the accuracy to a threshold may comprise comparing the difference to a threshold difference. In these examples in response to the accuracy not meeting the threshold repeating an iteration of adjusting the first setpoint value for at least some of the phase actuators may comprise in response to the difference being greater than the threshold difference repeating an iteration of adjusting the first setpoint value for at least some of the phase actuators. In these examples in response to the accuracy meeting a threshold storing the first setpoint values for each of the plurality of phase actuators in association with the first desired operation may comprise in response to the difference not being greater than the threshold difference storing the first setpoint values for each of the plurality of phase actuators in association with the first desired operation. This enables setpoint values to be used to determine whether an accuracy threshold has been met. This provides a simple way to determine whether an accuracy threshold has been met. An equivalent process can be used to determine the accuracy to which the second desired operation is implemented.

In other examples determining an accuracy to which the plurality of phase actuators implement the first desired operation comprises determining a fidelity of the first desired operation. In these examples comparing the accuracy to a threshold may comprise comparing the fidelity to a threshold fidelity. In these examples in response to the accuracy not meeting the threshold repeating an iteration of adjusting the first setpoint value for at least some of the phase actuators may comprise in response to the fidelity being less than the threshold fidelity repeating an iteration of adjusting the first setpoint value for at least some of the phase actuators. In these examples in response to the accuracy meeting a threshold storing the first setpoint values for each of the plurality of phase actuators in association with the first desired operation may comprise in response to the fidelity not being less than the threshold fidelity storing the first setpoint values for each of the plurality of phase actuators in association with the first desired operation. This enables the fidelity to be used as a measure of accuracy. This provides a useful way to measure the accuracy to which a desired operation is being implemented. An equivalent process can be used to determine the accuracy to which the second desired operation is implemented.

In some examples recharacterizing at least some of the plurality of phase actuators comprises one of: recharacterizing each phase actuator of the plurality of phase actuators; or recharacterizing each phase actuator of the plurality of phase actuators that has a setpoint value above a threshold; or recharacterizing each phase actuator of the plurality of phase actuators that is within a threshold distance of a phase actuator of the plurality of phase actuators that has a setpoint value above a threshold; or recharacterizing each phase actuator of the plurality of phase actuators that has a setpoint value which differs from a setpoint value of a neighbouring phase actuator by more than a threshold difference. Recharacterizing each phase actuator of the plurality of phase actuators ensures all crosstalk is effectively compensated for. Recharacterizing only phase actuators that have a setpoint value above a threshold, phase actuators that within a threshold distance of phase actuators that have a setpoint value above a threshold or phase actuators that have a setpoint value which differs from a setpoint value of a neighbouring phase actuator by more than a threshold difference recharacterizes phase actuators most likely to be subject to crosstalk while increasing the efficiency of the process of recharacterizing the phase actuators.

In some examples each setpoint value of the plurality of setpoint values comprises a setpoint voltage and the relationship between the phase and the adjustable parameter comprises a voltage-phase relationship; the voltage-phase relationship for a phase actuator is given by *φ* = *a* + *bV*² + *cV*³ + *dV*⁴ wherein *φ* is the phase of the actuator, V is the voltage of the phase actuator and a, b, c and d are constants; and characterizing the phase actuator comprises determining the constants a, b, c and d. Using setpoint voltages as the setpoint value can be convenient as it may be easy to set on a voltage source. Determining the constants a, b, c and d as part of the characterization can provide a convenient and accurate characterization of the phase actuators.

In some examples determining a first/second setpoint voltage for each phase actuator of the plurality of phase actuators comprises using the relationship *φ* = *a* + *bV*² + *cV*³ + *dV*⁴ and the values of constants a, b, c and d determined in the characterization to find the setpoint voltage from the target phase for the phase actuator. This provides a convenient way to determine the setpoint voltage from the target phase.

In other examples each setpoint value of the plurality of setpoint values comprises a setpoint current and the relationship between the phase and the adjustable parameter comprises a current-phase relationship; the current-phase relationship for a phase actuator is given by *φ* = *a* + *bI*² + *cI*³ + *dI*⁴ wherein *φ* is the phase of the actuator, I is the current of the phase actuator and a, b, c and d are constants; and characterizing the phase actuator comprises determining the constants a, b, c and d. In some cases, the source may be a current source or for other reasons it may be easier to have setpoint values in the form of current. Hence, current setpoint values can be used.

In other examples each setpoint value of the plurality of setpoint values comprises a setpoint voltage and the relationship between the phase and the adjustable parameter comprises a voltage-phase relationship. In these examples characterizing a phase actuator may comprise: setting a voltage of the phase actuator to each of several interval voltages; measuring a phase implemented by the phase actuator at each interval voltage; and storing the characterization as the phase implemented by the actuator at each respective interval voltage. This provides an example method for efficiently characterizing a phase actuator to determine a voltage-phase relationship.

In some examples setting a voltage of the phase actuator to each of several intervals comprises setting the phase actuator to a set of voltages between 0V and 15V, and optionally, wherein each voltage in the set is separated from the others by 0.15V or 0.3V. This provides away of characterizing the phase actuator that provides accurate results while keeping the number of overall measurements required relatively low. Thus, this provides an efficient way to accurately characterize the phase actuators.

In some examples determining a first/second target phase for each phase actuator such that when each phase actuator is set to its respective first/second target phase, the reconfigurable photonic integrated circuit implements the first/second desired operation comprises using a phase decomposition to determine the first/second target phases from the first/second desired operation. This provides a useful way for determining the first/second target phase from the first/second desired operation.

In some examples the reconfigurable photonic integrated circuit comprises: a plurality of phase shifters wherein each phase shifter is formed from a phase actuator of the plurality of phase actuators; and a plurality of tunable beam splitters wherein each tunable beam splitter is formed of a Mach-Zehnder interferometer with a phase shifter in one path or each/both paths of the Mach-Zehnder interferometer. This provides an example reconfigurable photonic integrated circuit in which the above method can be performed. However, the skilled person would understand that the above method can be performed in any suitable reconfigurable photonic integrated circuit that comprises phase actuators and that these phase actuators may be arranged in several ways and used to form several components and the above photonic integrated circuit is just one example.

It will also be apparent to anyone of ordinary skill in the art, that some of the preferred features indicated above as preferable in the context of one of the aspects of the disclosed technology indicated may replace one or more preferred features of other ones of the preferred aspects of the disclosed technology. Such apparent combinations are not explicitly listed above under each such possible additional aspect for the sake of conciseness.

Other examples will become apparent from the following detailed description, which, when taken in conjunction with the drawings, illustrate by way of example the principles of the disclosed technology.

### BRIEF DESCRIPTION OF THE DRAWINGS

Embodiments of the invention will be described, by way of example, with reference to the following drawings, in which:
Figure 1 is a flowchart showing an iterative method for determining setpoint values that cause a plurality of phase actuators to implement a desired operation in the presence of crosstalk;
Figure 2 is a flow diagram summarising the method shown in Figure 1;
Figure 3A is a graph showing how when the setpoint values are voltages the setpoint voltages change over each iteration of the method of Figures 1 and 2;
Figure 3B is a graph showing how the fidelity of the desired operation implemented by the reconfigurable photonic integrated circuit varies with the number of iterations of the methods of Figure 1 and Figure 2;
Figure 4A is an example reconfigurable photonic integrated circuit comprising a plurality of phase actuators and a plurality of tunable beam splitters that can be controlled using the methods of the present disclosure;
Figure 4B is an illustration of how a tunable beam splitter can be formed from two phase actuators and a waveguide path; and
Figure 5 is an example classical computing device that can be used to implement some of the calculations of the methods of the present disclosure.

The accompanying drawings illustrate various examples. The skilled person will appreciate that the illustrated element boundaries (e.g., boxes, groups of boxes, or other shapes) in the drawings represent one example of the boundaries. It may be that in some examples, one element may be designed as multiple elements or that multiple elements may be designed as one element. Common reference numerals are used throughout the figures, where appropriate, to indicate similar features.

### DETAILED DESCRIPTION

The following description is made for the purpose of illustrating the general principles of the present technology and is not meant to limit the inventive concepts claimed herein. As will be apparent to anyone of ordinary skill in the art, one or more or all of the particular features described herein in the context of one embodiment are also present in some other embodiment(s) and/or can be used in combination with other described features in various possible combinations and permutations in some other embodiment(s).

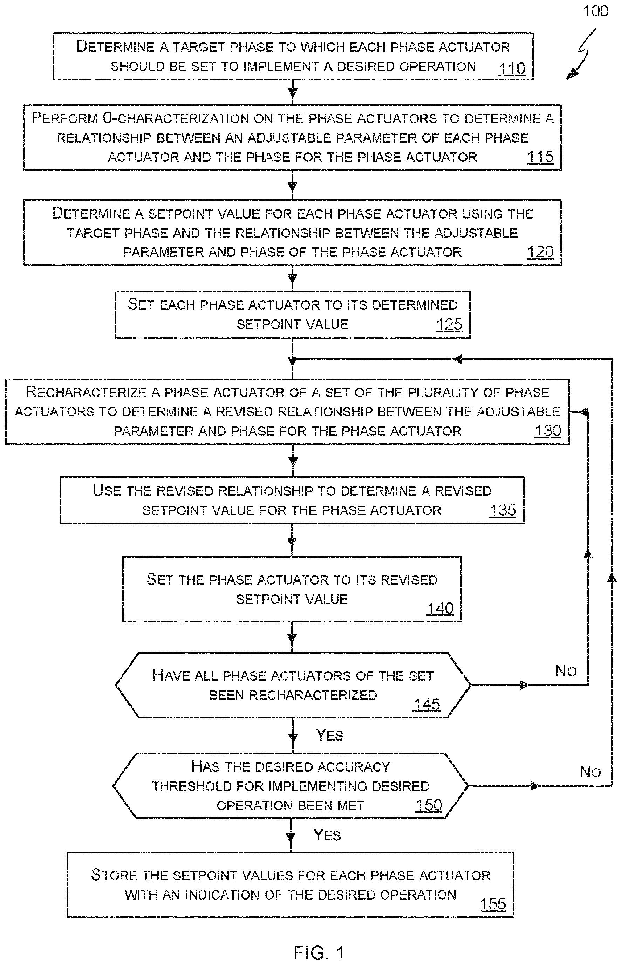

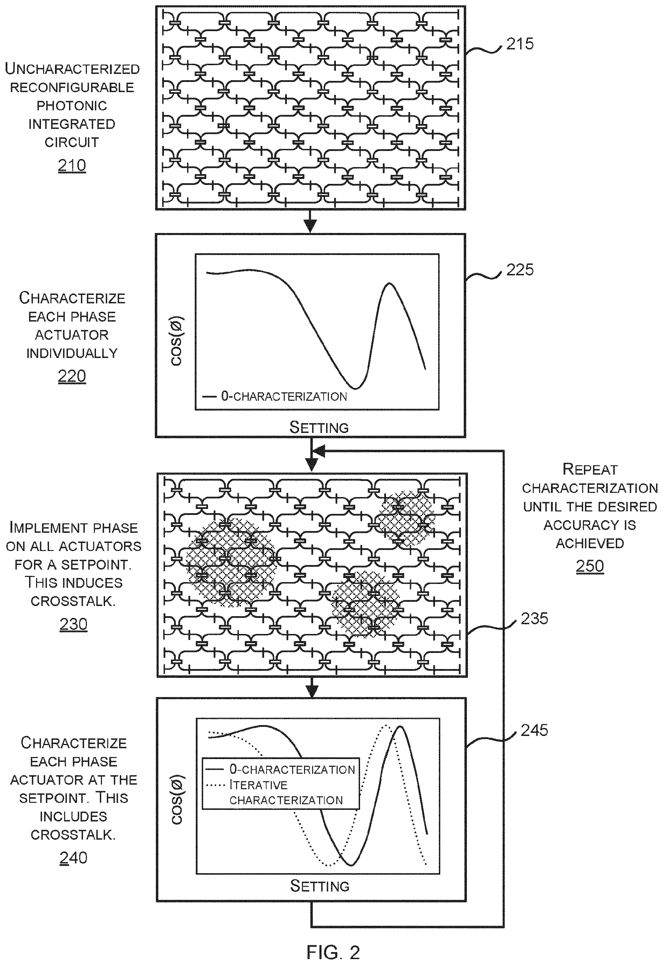

Figures 1 and 2 show an example method of determining a setpoint value for an adjustable parameter for each of a plurality of phase actuators in a reconfigurable photonic integrated circuit wherein setting the plurality of phase actuators to their respective setpoint values causes the reconfigurable photonic integrated circuit to implement a desired operation. In one example the phase actuators in the reconfigurable photonic integrated circuit are thermal phase actuators positioned on a waveguide. In other examples the phase actuators can be electro-optic, MEMS (micro-electromechanical system), piezo or stress-optic phase actuators on a waveguide. For example, when the phase actuators are thermal phase actuators, each thermal phase actuator may comprise a resistor positioned above the waveguide path. In other examples the resistor may be below or to the side of the waveguide path. The resistor may be connected into an electrical circuit with a voltage source via two metal leads. The voltage source can be used to apply a voltage over the resistor and hence cause a current to flow through the resistor. This results in the dissipation of heat as power, for example in accordance with power = voltage × current. The heat warms up the waveguide and since the refractive index of the waveguide is a function of temperature, this induces a phase shift within the waveguide through the thermo-optic effect. This phase shift is applied to any light passing through the phase actuator. The phase actuator may be controlled by using the voltage source to control the voltage, current or dissipated thermal power of the phase actuator. Hence, the setpoint value may comprise a setpoint voltage, a setpoint current or a setpoint dissipated thermal power. In other examples, when electro-optic, MEMS or stress-optic phase actuators are used the setpoint values may comprise a setpoint electrical, mechanical or stress value.

The desired operation is an operation that the user wishes to apply to light states passing through the reconfigurable photonic integrated circuit. In some examples this can be represented by a matrix relating the input modes to the output modes which can be unitary for a square network/matrix. When the reconfigurable photonic integrated circuit is being used for quantum computing the desired operation may comprise a unitary operation (also referred to as a unitary) and the light states might comprise e.g. photonic qubits, laser light, or squeezed light states. The unitary may reflect the evolution/operation that needs to be applied to the photonic qubits (or other light states such as squeezed light states) in order to implement a quantum algorithm or part of a quantum algorithm. In this way the quantum algorithm is implemented on the light states through direct application of the unitary on the light states. The direct application of a unitary can also be used for photonic machine learning and matrix multiplications that use classical light as inputs. This direct application of the unitary results from the light states passing through the reconfigurable photonic integrated circuit rather than through the application of individual quantum gates. However, it is noted that the reconfigurable photonic integrated circuit could also be set up to implement operations comprising quantum gates if desired by the user. In other examples the reconfigurable photonic integrated circuit can be used for optical switching and/or optical routing. In this case the desired operation may reflect the desired routing paths for light states entering the reconfigurable photonic integrated circuit. This may enable the reconfigurable photonic integrated circuit to be used as part of a photonic network. In further examples the reconfigurable photonic integrated circuit can be used for filtering of light signals by tunable filters such as ring resonators. Other uses of the reconfigurable photonic integrated circuit can be anticipated with the desired operation reflecting an operation/unitary/evolution/action that should be applied to any light states/photonic qubits/squeezed light states when the light states/photonic qubits/squeezed light states pass through the reconfigurable photonic integrated circuit.

The method of determining setpoint values starts in step 110 of Figure 1 where the target phase that each phase actuator needs to be set to in order to implement the desired operation is determined. The target phase each phase actuator needs to be set to can be determined in any known way. For example, the desired operation may be a desired unitary transform and the target phase for each phase actuator may be determined using any suitable known phase decomposition such as a Clements decomposition, or a Reck decomposition. Other ways of determining a target phase for each phase actuator from a desired operation can also be used.

In step 115 of Figure 1, the method comprises performing a 0-characterization on each phase actuator in the reconfigurable photonic integrated circuit. This involves characterizing each phase actuator of the plurality of phase actuators individually while all other phase actuators of the plurality of phase actuators are switched off. This involves characterizing each phase actuator of the plurality of phase actuators while each phase actuator is free from crosstalk (since the other phase actuators are switched off and not causing crosstalk). The characterizing of each phase actuator involves determining a relationship between an adjustable parameter of the phase actuator and the resultant phase of the phase actuator. This relationship is then stored or otherwise used as a characterization of the phase actuator.

In one example, the adjustable parameter of the phase actuator can be a voltage of the phase actuator. In this example, the relationship between the adjustable parameter and the phase of the phase actuator comprises a voltage-phase relationship for the phase actuator. This voltage-phase relationship is stored or otherwise used as a characterization of the phase actuator. In one example, this characterization may take the form of a higher-order polynomial of the applied voltage e.g. *φ* = *a* + *bV*² + *cV*³ + *dV*⁴ wherein *φ* is the phase of the actuator, V is the voltage of the phase actuator and a, b, c and d are constants that are determined as part of the characterization. However, the characterization may also take other forms dependent upon the phase actuators used. For example, depending on the fabrication of a heater of the phase actuator (for example the resistor described above) more or fewer polynomial terms may be used in the above equation.

In another example, the adjustable parameter of the phase actuator can be a current of the phase actuator. In this example, the relationship between the adjustable parameter and the phase comprises a current-phase relationship for the phase actuator. This current-phase relationship is stored or otherwise used as a characterization of the phase actuator. In one example, this characterization may take the form of a higher-order polynomial of the current e.g. *φ* = *a + bI*² + *cI*³ + *dI*⁴ where *φ* is the phase of the actuator, I is the current in the phase actuator and a, b, c and d are constants that are determined as part of the characterization. However, as above, the characterization may also take other forms dependent upon the phase actuators used. For example, depending on the fabrication of a heater of the phase actuator (for example the resistor described above) more or fewer polynomial terms may be used in the above equation.

In a further example, the adjustable parameter of the phase actuator can be a dissipated thermal power over the phase actuator. In this example, the relationship between the adjustable parameter and the phase comprises a dissipated thermal power-phase relationship for the phase actuator. In one example, this characterization may take the form of a higher-order polynomial of the dissipated thermal power e.g. *φ* = *a + bP* + *cP*² + *dP³* where *φ* is the phase of the actuator, P is the dissipated thermal power and a, b, c and d are constants that are determined as part of the characterization. However, as above, the characterization may also take other forms dependent upon the phase actuators used. For example, depending on the fabrication of a heater of the phase actuator (for example the resistor described above) more or fewer polynomial terms may be used in the above equation.

In an additional example, the adjustable parameter of the phase actuator can be an applied stress. In this example, the relationship between the adjustable parameter and the phase comprises an applied stress-phase relationship for the phase actuator. The skilled person would understand other adjustable parameters and relationships can be used dependent on the form of the phase actuators.

Characterizing each phase actuator while the other phase actuators are switched off may involve varying a value of the adjustable parameter of the phase actuator and measuring the corresponding output phase of the phase actuator. For example, when the adjustable parameter is voltage, this can involve varying a voltage being passed through the phase actuator and measuring the corresponding output phase of the phase actuator. This can be done by varying the voltage to which the phase actuator is set and measuring the phase implemented by the phase actuator. For example, this may involve setting the phase actuator to one of several interval voltages in the range 0V to 15V and measuring the phase at each of these interval voltages. The interval voltages may be every 0.1V, 0.15V, 0.2V or every 0.3V, although even more frequent interval voltages can be used in some examples. In some examples, a total of 50 or 100 interval voltages may be used between 0V to 15V so the interval voltages are every 0.3V or 0.15V. When the adjustable parameter is current, varying a value of the adjustable parameter can involve varying a current of the phase actuator between, for example 0mA and 70mA, and measuring the corresponding output phase of the phase actuator, for example by setting the current to one of several interval currents and measuring the phase of the phase actuator at these interval currents. Similarly, when the adjustable parameter is dissipated thermal power, varying a value of the adjustable parameter can involve varying the dissipated thermal power between, for example 0mW and 500mW, and measuring the corresponding output phase of the phase actuator, for example by setting the dissipated thermal power to one of several interval dissipated thermal powers and measuring the corresponding output phase of the phase actuator. When the adjustable parameter is an applied stress, varying a value of the adjustable parameter can involve varying the applied stress and measuring the corresponding output phase of the phase actuator. The skilled person would understand that depending upon the form of the phase actuator, other adjustable parameters could be used. In some examples the characterization of each phase actuator may be stored for further use.

At step 120 of Figure 1, the method further comprises determining a setpoint value for the adjustable parameter of each phase actuator of the plurality of phase actuators using the characterization of the respective phase actuator and the determined target phase for the phase actuator. For example, this can involve using the characterization of the phase actuator to determine a setpoint value for the adjustable parameter at which the target phase for the phase actuator will be achieved according to the characterization of the phase actuator.

For example, determining a setpoint value for each phase actuator may comprise determining a setpoint voltage for each phase actuator. Determining a setpoint voltage for each phase actuator can involve using the characterization of the phase actuator to determine a setpoint voltage at which the target phase for the phase actuator will be achieved according to the characterization of the phase actuator. When the relationship between phase and voltage takes the form *φ* = *a* + *bV*² + *cV*³ + *dV⁴* wherein *φ* is the phase of the actuator, V the voltage of the phase actuator and the characterization has determined the constants a, b, c and d then determining the setpoint voltage can involve using the constants to determine a setpoint voltage from the target phase.

In another example, determining a setpoint value for each phase actuator may comprise determining a setpoint current for each phase actuator. Determining a setpoint current for each phase actuator can involve using the characterization of the phase actuator to determine a setpoint current at which the target phase for the phase actuator will be achieved according to the characterization. When the relationship between phase and current takes the form *φ* = *a* + *bI*² + *cI*³ + *dI*⁴ wherein *φ* is the phase of the actuator, I the current and the characterization has determined the constants a, b, c and d then determining the setpoint current can involve using the constants to determine a setpoint current from the target phase.

In a further example, determining a setpoint value for each phase actuator may comprise determining a setpoint dissipated thermal power for each phase actuator. Determining a setpoint dissipated thermal power for each phase actuator can involve using the characterization of the phase actuator to determine a setpoint dissipated thermal power at which the target phase for the phase actuator will be achieved according to the characterization. When the relationship between phase and current takes the form *φ* = *a* + *bP* + *cP*² + *dP³* wherein *φ* is the phase of the actuator, P the dissipated thermal power and the characterization has determined the constants a, b, c and d then determining the setpoint dissipated thermal power can involve using the constants to determine a setpoint dissipated thermal power from the target phase.

In even further examples, the determining a setpoint value for each phase actuator may comprise determining a setpoint applied stress for each phase actuator. Determining a setpoint applied stress for each phase actuator can involve using the characterization of the phase actuator to determine a setpoint applied stress at which the target phase for the phase actuator will be achieved according to the characterization. The skilled person would understand that depending upon the form of the phase actuator and adjustable parameter, other forms of setpoint value could also be considered.

It will be understood that depending upon the form of the desired operation/unitary transform the setpoint value for many of the actuators may be zero. For example, the setpoint voltage, setpoint current, setpoint dissipated thermal power. or setpoint applied stress may be zero. However, the method in Figure 1 is applicable even if none of the setpoint values are zero.

At step 125 of Figure 1, the method comprises setting each phase actuator to the determined setpoint value of the adjustable parameter. This may involve adjusting the voltage of each phase actuator to its respective setpoint voltage, adjusting the current of each phase actuator to its respective setpoint current, adjusting the dissipated thermal power of each phase actuator to its respective setpoint dissipated thermal power, or adjusting the applied stress of each phase actuator to its respective setpoint applied stress. In the absence of any crosstalk, setting each phase actuator to its setpoint value would result in each actuator being set to the target phase and hence the reconfigurable photonic integrated circuit implementing the desired operation. However, in reconfigurable photonic integrated circuits the phase actuators experience crosstalk due to the closeness of the phase actuators. This crosstalk results in spatial correlations between the phase-setting relationships of phase actuators. For example, phase actuators, such as thermal phase actuators experience thermal crosstalk due to the parasitic heating of neighbouring light paths and parasitic heating and conducting through the electrical connections between the phase actuators. For example electrical connections such as electrical leads may heat up waveguide paths at locations on the chip away from the phase actuator. Phase actuators such as thermal phase actuators may experience electrical crosstalk between interconnected electrical circuits when a voltage or current applied to one phase actuators alters the voltage or current on another phase actuator. Other forms of crosstalk such as stress-optic and electro-optic crosstalk may also be experienced depending on the form of the phase actuators. The crosstalk results in parasitic phase shifts on each phase actuator, distorting the target phase. This reduces the accuracy of the phase implemented by each phase actuator and the resultant operation implemented by the reconfigurable photonic integrated circuit. As a result of the crosstalk the phase actuators will be subject to parasitic phase shifts meaning the phase actuators do not implement the target phases perfectly and hence do not perfectly implement the desired operation. Therefore, setting each phase actuator to the determined setpoint value of the adjustable parameter will not perfectly implement the desired operation. When the reconfigurable photonic integrated circuit is large, for example contains more than 100 of phase actuators then the accuracy of the desired operation may reduce beyond the point of usefulness. However, even in smaller systems the crosstalk may have a significant impact on the accuracy of the desired operation.

Given the above, once the initial setpoint values for the adjustable parameter of each phase actuator has been obtained an iterative process can be used to find an improved setpoint value for the adjustable parameter in the presence of crosstalk by recharacterizing the phase actuators in an iterative manner. This iterative process finds setpoint values that implement the target phases in the presence of crosstalk.

In each iteration of the iterative process a set/group of at least some of the plurality of phase actuators are recharacterized. This set/group may comprise all of the plurality of phase actuators. As such, in each iteration all of the plurality of phase actuators may be recharacterized. While this improves accuracy, it can be time consuming when the reconfigurable photonic integrated circuit comprises a large number of phase actuators. As such, in other examples only the phase actuators likely to be subject to crosstalk are recharacterized in each iteration. This can, for example, involve only recharacterizing phase actuators with a setpoint value above a threshold, phase actuators within a threshold distance of other phase actuators with a setpoint value above a threshold and/or phase actuators that have a setpoint value that differs from the setpoint value of a neighbouring phase actuator by more than a threshold difference. As mentioned above, in some examples, the setpoint value can be a setpoint voltage, a setpoint current or a setpoint dissipated thermal power. In other examples the setpoint value may be a setpoint applied stress. As such, the threshold may be a threshold voltage, a threshold current, a threshold dissipated thermal power, or a threshold applied stress respectively and/or the threshold difference may be a threshold voltage difference, a threshold current difference, a threshold dissipated thermal power difference, and/or a threshold applied stress difference respectively.

In one example, where a voltage threshold is used, the voltage threshold can be 0V and all phase actuators that have a setpoint above 0V and/or which are within a threshold distance of another phase actuator with a setpoint voltage above 0V are recharacterized. This can reduce the number of phase actuators that need to be recharacterized and thus speed up the determining of setpoint voltages while ensuring any phase actuator likely to be subject of crosstalk is set correctly. In another example, where a voltage threshold is used, the threshold voltage may be a relatively high voltage, for example, 10V, and phrase actuators with a setpoint above this voltage and/or within a threshold distance of another phase actuator with a setpoint above this voltage may be recharacterized.

When a current threshold is used, the current threshold can be 0A and all phase actuators that have a setpoint above 0A and/or which are within a threshold distance of another phase actuator with a setpoint current above 0A are recharacterized. In another example, when a threshold current is used, the threshold current may be a relatively high current, for example, 50mA and phase actuators with a setpoint above this current may be recharacterized.

When a dissipated thermal power threshold is used, the dissipated thermal power threshold can be 0W and all phase actuators that have a setpoint above 0W and/or which are within a threshold distance of another phase actuator with a setpoint dissipated thermal power above 0W are recharacterized. In another example, when a threshold dissipated thermal power is used, the threshold dissipated thermal power may be a relatively high dissipated thermal power, for example, 300mW, and phase actuators with a setpoint above this dissipated thermal power may be recharacterized.

As mentioned above, in some examples the threshold may be a threshold difference in the setpoint value of the adjustable parameter wherein the difference in setpoint values is a difference between the setpoint value of a phase actuator and the setpoint value of a neighbouring phase actuator. When the setpoint values are voltages, the threshold setpoint difference may be 6V, when the setpoint values are currents, the threshold setpoint difference may be 25mA and when the setpoint values are dissipated thermal powers then the threshold setpoint difference may be 200mW.

Thus, by only characterizing phase actuators with a setpoint value above a threshold, phase actuators near a phase actuator with a setpoint value above this threshold and/or phase actuators that have a setpoint value that differs from the setpoint value of a neighbouring phase actuator by more than a threshold difference, it is possible to reduce the number of phase actuators that need to be recharacterized while still compensating for the majority of crosstalk. When a threshold distance is used, the threshold distance between phase actuators can depend on the density of phase actuators in the reconfigurable photonic integrated circuit. However, in some examples the threshold distance may be a distance in terms of phase actuators and may comprise only phase actuators neighbouring the phase actuator with the setpoint above the voltage threshold or only phase actuators separated from the phase actuator above the threshold by one, two, or three other phase actuators. The separation may be based on a geometric layout of the phase actuators or may be based on connections between the phase actuators via light paths or electrical leads/connections between the phase actuators since conduction may lead to non-trivial long-distance correlations.

The method for each iteration involves updating/revising the characterization of each of the phase actuators in the set/group of phase actuators wherein the set/group comprises at least some of the plurality of phase actuators. In each iteration the phase actuators in the set/group of phase actuators are considered in turn.

In step 130, the method comprises characterizing a phase actuator from the set/group of the plurality of phase actuators while all other phase actuators of the plurality of phase actuators are set to their setpoint values. This step can be referred to as recharacterizing the phase actuator. This involves characterizing a phase actuator while it is subject to crosstalk from other phase actuators of the plurality of phase actuators. As mentioned above, in some examples the setpoint values of some of the phase actuators may be zero. In this case a phase actuator being set to its setpoint value can comprise the phrase actuator being off (or set to zero) when the setpoint value is zero. As before characterizing the phase actuator can comprise varying a value of the adjustable parameter of the phase actuator and measuring the resultant phase of the phase actuator. For example, when the adjustable parameter is a voltage, characterizing the phase actuator can comprise varying a voltage being passed through the phase actuator and measuring the resultant phase of the phase actuator. In another example, when the adjustable parameter is a current, characterizing the phase actuator can comprise varying a current being passed through the phase actuator and measuring the resultant phase of the phase actuator. In a further example, when the adjustable parameter is a dissipated thermal power then characterizing the phase actuator can comprise varying the dissipated thermal power of the phase actuator and measuring the resultant phase of the phase actuator. When the adjustable parameter is an applied stress, characterizing the phase actuator can comprise varying an applied stress of the phase actuator and measuring the resultant phase of the phase actuator. The results of this characterizing comprise an updated or revised characterization of the phase actuator in the form of a revised relationship between the adjustable parameter and the phase such as the relationships discussed above. In some examples, this revised relationship can comprise a revised voltage-phase relationship which may comprise a revised set of constants a, b, c, and d for the equation *φ* = *a* + *bV*² + *cV³* + *dV*⁴ as described above. In other examples this relationship can comprise a revised current-phase relationship which may comprise a revised set of contacts a, b, c and d for the equation *φ* = *a* + *bI*² + *cI*³ + *dI*⁴ as described above. In further examples, this revised relationship may comprise a revised dissipated thermal power-phase relationship which may comprise a revised set of constants a, b, c and d for the equation *φ* = *a* + *bP* + *cP*² + *dP*³ as described above.

In step 135, the method comprises using the recharacterization for the phase actuator to determine a new or revised setpoint value for the phase actuator. This can be done by using the updated/revised characterization for the phase actuators to find a setpoint value at which the target phase for that phase actuator is implemented. For example, when the characterization is a voltage-phase relationship then the voltage-phase relationship can be used to find a setpoint voltage at which the target phase is implemented. In another example, when the characterization is a current-phase relationship then the current-phase relationship can be used to find a setpoint current at which the target phase is implemented. In a further example, when the characterization is a dissipated thermal power-phase relationship then the dissipated thermal power-phase relationship can be used to find a setpoint dissipated thermal power at which the target phase is implemented. When the characterization is an applied stress-phase relationship then the applied stress-phase relationship can be used to find a setpoint applied stress at which the target phase is implemented. It is noted that while it is expected the above recharacterization will often lead to the new or revised setpoint value being different from the original setpoint value (e.g. the setpoint value at the start of an iteration or before the recharacterization) this may not necessarily be the case in all circumstances. Thus, it is possible that the new/revised setpoint value is the same as the setpoint value at the start of the iteration e.g. the unrevised setpoint value for that phase actuator.

In step 140, the method comprises setting the phase actuator to its new or revised setpoint value. Given this new/revised setpoint value was determined while the other phase actuators of the plurality of phase actuators were set to their setpoint value, this new/revised setpoint value represents a setpoint value that will more accurately implemented the target phase even in the presence of crosstalk from the other phase actuators of the plurality of phase actuators. If as mentioned above, the new/revised setpoint value is the same as the setpoint value at the start of the iteration then the setpoint value for the actuator may not require adjusting in this step.

In step 145, the method may comprise determining whether all phase actuators of the group/set of the plurality of phase actuators have been recharacterized and set to their new/revised setpoint values. If they have not then the method for recharacterizing a phase actuator outlined in steps 130, 135 and 140 above is repeated for another phase actuator from the set/group of phase actuators. Any phase actuators that have already been recharacterized and set to a revised setpoint value may remain at the revised setpoint value when steps 130, 135 and 140 are repeated for further phase actuators from the set/group of phase actuators. In this way the method can be considered to cycle through the phase actuators. The phase actuators may be cycled through in any logical order. In one example the phase actuators may be cycled through in an order that makes it easy for a user to follow for example by starting at the top left and moving to the bottom right or using another logical geometric order. However, other orders may be used. If all the phase actuators from the set/group of phase actuators have been recharacterized and set to their new/revised setpoint voltages, then the method may proceed to step 150.

In step 150, the method comprises determining whether a desired accuracy threshold for implementing the desired operation is met with each phase actuator of the plurality of phase actuators set to the setpoint values at the end of the iteration. For a phase actuator, the setpoint value at the end of an iteration may comprise the revised/new setpoint value determined in the iteration. If the setpoint value and/or characterization is not updated in an iteration, then the setpoint value at the end of the iteration may comprise the setpoint value at the start of the iteration.

In one example determining whether or not a desired accuracy threshold is met comprises determining a measure of fidelity and then comparing this fidelity to a threshold. In order to determine the fidelity each phase actuator of the plurality of phase actuators is set to its setpoint value. Light, such as laser light, for example laser light with a wavelength and polarization supported by the waveguides between the phase actuators, is injected into an input of the reconfigurable photonic integrated circuit and all outputs of the reconfigurable photonic integrated circuit are measured simultaneously. In other examples single photons or other states of light such as squeezed light states may be used in place of laser light. This step of injecting light into an input of the reconfigurable photonic integrated circuit and measuring all outputs is repeated for all inputs of the reconfigurable photonic integrated circuit. These measurements result in an N×N intensity matrix wherein N is the number of inputs and number of outputs in the reconfigurable photonic integrated circuit. When laser light is used then these measurements can involve measuring an intensity matrix directly. When single photons are used then a photon count can be used to determine the N×N intensity matrix. The N×N intensity matrix is corrected for detector dark counts and port-dependent losses using known techniques. A square root of the corrected N×N matrix is taken using known techniques and the result is an amplitude matrix. As mentioned above, a target phase has been determined for each phase actuator. These target phases can be used to form a matrix which is the target matrix for the operation. An overlap between the amplitude matrix and the target matrix provides a measure of fidelity. This fidelity can then be compared to a threshold to determine whether or not a desired accuracy threshold has been met. In one example the fidelity threshold may be 99% and if the fidelity is either at or above this threshold then the desired accuracy can be considered met. In contrast if the desired fidelity is either below or not at the threshold then the desired accuracy may not be considered met.

In another example determining whether or not a desired accuracy threshold is met can comprise determining a degree to which the updated/revised setpoint values differ from the setpoint values which were used at the start of an iteration e.g. from the setpoint values determined in the previous iteration, or if this iteration is the first iteration, the setpoint values determined in step 125. In other words whether or not a desired accuracy threshold is met can be determined by comparing the setpoint values to which each phase accurate is set at the start of an iteration to the updated/revised setpoint values at the end of the iteration. If the differences are within/below/not above a threshold then it can be determined the desired accuracy would be obtained using the updated/revised setpoint values. In contrast, if the differences are not within/not below/above a threshold then it can be determined the desired accuracy would not be obtained. This comparison enables a determination as to whether a desired accuracy would be met since if the setpoint value does not change by much between iterations then it can be determined that any crosstalk in the reconfigurable photonic integrated circuit has already been compensated for by previous iterations. In one example the differences between the setpoint values at the start of an iteration (e.g. the original setpoint values) and the updated/revised setpoint values (e.g. the setpoint values to which the phase actuators are set at the end of an iteration) can be an average of the difference for each phase actuator of the plurality of phase actuators. In another example, the sum of the differences between the setpoint at the start of the iteration and the updated/revised setpoint can be used for all phase actuators of the phase plurality of actuators. In some examples, instead of using all phase actuators, the difference calculation may only consider phase actuators not set to zero. The threshold difference will depend on the purpose of the reconfigurable photonic integrated circuit and the desired accuracy needed with regard to that purpose. However, in one example the desired accuracy may be voltage accuracy of around 0.1V or 0.2V.

In another example, determining whether or not a desired accuracy threshold is met can comprise using the updated characterization obtained in step 130 to determine an actual phase implemented by each phase actuator at the setpoint value at the start of the iteration e.g. the setpoint value determined in the previous iteration or if this is the first iteration, the setpoint value determined at step 125. Given the characterization of the phase actuator comprises a relationship between the adjustable parameter and phase, this can involve using the characterization to determine an actual phase implemented by the phase actuator at the setpoint value from the start of the iteration.

For example, as mentioned above when the relationship between the adjustable parameter and phase is a voltage-phase relationship, the relationship may take the form *φ* = *a* + *bV*² + *cV³* + *dV*⁴ wherein *φ* is the phase of the actuator, V is the voltage of the actuator and a, b, c and d are constants that are determined as part of the characterization. Determining the actual phase implemented by the setpoint voltage at the start of an iteration may thus involve using the values of a, b, c and d obtained as part of the re-characterization and the voltage setpoint from the start of the iteration to determine an actual phase implemented by the phase actuator when it is set to the voltage setpoint from the start of the iteration.

In another example, as mentioned above when the relationship between the adjustable parameter and phase is a current-phase relationship, the relationship may take the form *φ* = *a* + *bI*² + *cI*³ + *dI*⁴ wherein *φ* is the phase of the actuator, I is the current of the actuator and a, b, c and d are constants that are determined as part of the characterization. Determining the actual phase implemented by the setpoint current at the start of an iteration may thus involve using the values of a, b, c and d obtained as part of the re-characterization and the setpoint current from the start of the iteration to determine an actual phase implemented by the phase actuator when it is set to the setpoint current from the start of the iteration.

In a further example, as mentioned above when the relationship between the adjustable parameter and phase is a dissipated thermal power-phase relationship, the relationship may take the form *φ* = *a* + *bP* + *cP*² + *dP³* wherein *φ* is the phase of the actuator, P is the dissipated thermal power and a, b, c and d are constants that are determined as part of the characterization. Determining the actual phase implemented by the setpoint dissipated thermal power at the start of an iteration may thus involve using the values of a, b, c and d obtained as part of the re-characterization and the setpoint dissipated thermal power from the start of the iteration to determine an actual phase implemented by the phase actuator when it is set to the setpoint dissipated thermal power from the start of the iteration.

Once obtained, the actual phase for each phase actuator can then be compared with the target phase for each phase actuator to determine whether a desired accuracy of the target operation has been obtained. In some examples this is done by determining an average of the differences between the actual phases and the target phases and comparing this to a threshold. If the average difference is within/below/not above the threshold then the desired accuracy can be considered met. In contrast, if the average difference is not within/not below/above the threshold then the desired accuracy can be considered to not be met. In other examples this is done by determining a sum of the differences between the actual phases and the target phases and comparing this to a threshold. Again if the sum of the differences is within/below/not above a threshold the target accuracy can be considered to be met. In contrast, is the sum of the differences is not within/not below/above the threshold then the target accuracy can be considered to not be met. In further examples this is done by using the actual phases to calculate an actual operation that will be implemented by the reconfigurable photonic integrated circuit. This can then be compared with the desired operation to see if the desired operation is implemented to a desired accuracy. If the difference between the desired operation and actual operation is within/below/not above a threshold then the target accuracy can be considered met. If the desired accuracy if not within/not below/above a threshold then the target accuracy can be considered not to be met. The target accuracy may depend on the form of the desired operation and the required accuracy for any quantum computation, quantum routing, quantum machine learning, and/or filtering application etc.

If the desired accuracy threshold has not been met, then another iteration of characterizing the phase actuators is performed. This involves performing another iteration of updating/revising the characterization of each of the phase actuators in the set/group of phase actuators wherein the set/group comprises the at least some of the plurality of phase actuators. Therefore, this involves repeating steps 130 to 145 for the phase actuators in the set/group of phase actuators. In each iteration the setpoint values for at least some of the phase actuators is corrected to compensate for crosstalk from others of the plurality of phase actuators. However, this may also adjust the crosstalk if some of the others of the plurality of phase actors are also adjusted. Repeating the recharacterization in this iterative fashion means the adjustments of the other phase actuators are taken into account. As the adjustments become smaller, the degree to which the crosstalk changes between iterations is reduced. This means that the iterative process converges towards finding setpoint voltages that implement the target phases and hence the desired operation.

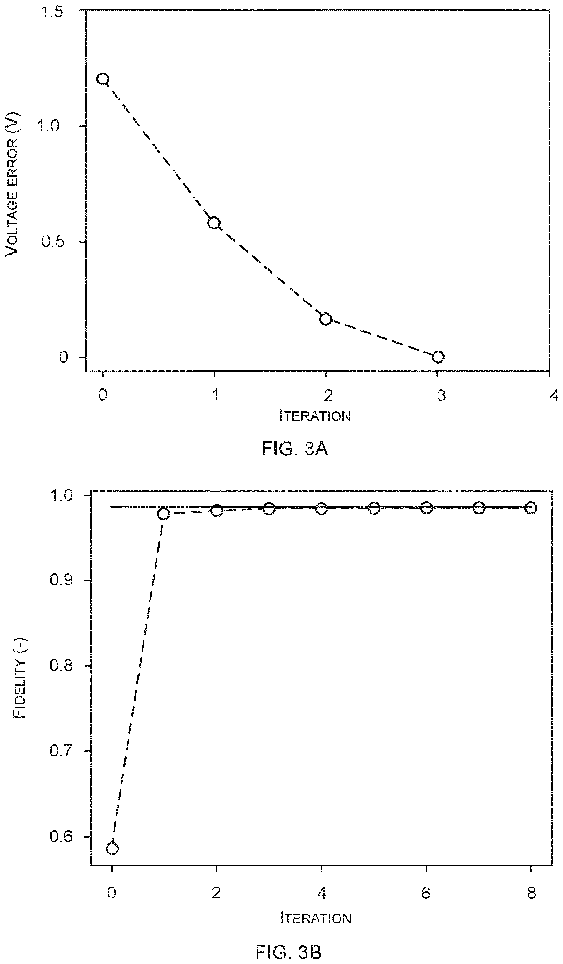

As shown in Figures 3A and 3B this process typically takes around 2 to 3 iterations to be able to implement the desired operation to a suitable accuracy. Figure 3A shows how the voltage error changes between iterations and Figure 3B shows how the fidelity of the desired operation changes between operations. In Figure 3A iterations of the above method are performed until the voltage setpoints for each phase actuator converge. The resultant voltage setpoints after this convergence can be referred to as convergence voltages. The voltage error in Figure 3A is an average over the phase actuators of the difference between the voltage setpoint at a particular iteration and the convergence voltage setpoint as determined for each phase actuator. As can be seen in Figure 3A, the voltage error drops below 0.1V within 3 iterations. Figure 3B shows how the fidelity of the of the desired operation implemented by the phase actuators in the reconfigurable photonic integrated circuit changes with the number of iterations. The fidelity can be determined as described above. As can be seen in Figure 3B, the fidelity tends to rise above at least 99% within three iterations. Figures 3A and 3B are examples of how voltage error/fidelity change with the number of iterations. Figures 3A and 3B are experimental results for setpoints that have each phase actuator have a target phase of 0 radians and wherein the reconfigurable photonic integrated circuit comprises 132 heaters/resistors.

If the desired accuracy threshold has been met, then in step 155 the method comprises storing the setpoint values for each phase actuator along with a representation or indication of the desired operation. In some examples the target phases may also be stored. Storing the setpoint voltages along with the target operation means that when a user wishes to use the reconfigurable photonic integrated circuit to implement the desired operation they are able to access the setpoint values for the adjustable parameter and set up the phase actuators as required.

The above provides a method for characterizing a reconfigurable photonic integrated circuit to determine a set of setpoint values for the phase actuators of reconfigurable photonic integrated circuit that implement a desired operation while compensating for crosstalk. This enables a large reconfigurable photonic integrated circuit that is likely to have crosstalk between its phase actuators to be used for photonic networks or quantum computing. In addition, this method is faster than, for example, measuring all phase actuator interactions to measure crosstalk since that process scales quadratically with the number of phase actuators while the above process only scales linearly with the number of phase actuators. The above method also provides a more accurate method of compensating for crosstalk since measuring crosstalk requires very precise measurements that are prone to accuracy errors. Thus, the above method both has improved efficiency and improved accuracy over other possible methods of compensating for crosstalk.

In some examples, the above method may further comprise using the determined setpoint values to implement the desired operation. This involves setting each phase actuator of the plurality of phase actuators to its setpoint value. The appropriate light states, photonic qubits, or squeezed light states can then be passed through the reconfigurable photonic integrated circuit, and this results in the reconfigurable photonic integrated circuit implementing the desired operation on the light states, photonic qubits, or squeezed light states. As such, once the setpoint values for the phase actuators have been found in accordance with the method above, they can be used to implement the desired operation.

The crosstalk a phase actuator experiences depends on the setpoint value of other phase actuators from the plurality of phase actuators. If a user wishes to use the reconfigurable photonic integrated circuit to implement a second desired operation, then a second set of target phases and second setpoint values need to be determined. The second set of target phases can be determined from the second desired operation using any suitable decomposition such as the decomposition schemes mentioned above. If the second desired operation is sufficiently close to the previous (e.g. first) desired operation in that the setpoint values of each phase actuator are sufficient similarly between the first and second desired operation, then the characterizations for each phase actuator found in the above method can be used to determine second setpoint values based on the second target phases. The setpoint values for the second operation can be determined initially from the target phases for the second desired operation and the iterative characterization obtained for the first desired operation. If the setpoint values are sufficiently similar, then the setpoint values from this iterative characterization can be used as second setpoint values that implement the second desired operation. However, if the setpoint values from this iterative characterization differ from the previous (e.g. first) setpoint values by more than a threshold then the differences in crosstalk may mean the previous (e.g. first) characterization will be ineffective for the second target phases and second desired operation. Therefore, the method may further comprise repeating the method above for a second desired operation.

The method may thus comprise determining a second target phase for each phase actuator based on the second desired operation. This may be performed as previously described with respect to box 110.

The method may then comprise obtaining a characterization of each phase actuator from the plurality of phase actuators when all other phase actuators are turned off. This may be done by characterizing each phase actuator of the plurality of phase actuators when the other phase actuators are turned off as described with respect to box 115. However, it is noted that this characterization when all other phase actuators are turned off may not have changed from the characterization in step 115 above. Therefore, the characterization may be obtained simply by obtaining a previously stored characterization for each phase actuator when the other phase actuators are turned off. The characterization of a phase actuator when all other phase actuators are turned off may be referred to as a 0-characterization.

Once the 0-characterization for each phase actuator has been determined, the method may comprise determining a second setpoint value for the adjustable parameter of each phase actuator based on the second target phase and the 0-characterization of each phase actuator. This can be performed as discussed with regard to box 120.

The method can then comprise setting each phase actuator of the plurality of phase actuators to its second determined setpoint value. This can be performed as discussed with respect to box 125.

An iterative process to compensate for crosstalk when performing the second desired operation can then be performed. This process is equivalent to the process described with respect to boxes 130 to 150 above. In particular, this process involves cycling through a set or group of phase actuators for each iteration. The set or group of phase actuators cycled through can be all of the plurality of phase actuators. However, in other examples the set/group of phase actuators cycled through may be phase actuators with a second setpoint value above a threshold, phase actuators within a threshold distance of phase actuators that have a second setpoint value above a threshold and/or phase actuators that have a second setpoint value that differs from the setpoint value of a neighbouring phase actuator by more than a threshold difference.

The method comprises for a phase actuator from the set/group, recharacterizing the phase actuator with the other phase actuators of the plurality of phase actuators set to their setpoint values to obtain a second revised characterization. This can be done, for example, as described with respect to box 130 above. The method then comprises determining a new/revised second setpoint value for the phase actuator based on the second target phase and the second revised characterization. This can be done, for example, as described with respect to box 135 above. The method then comprises setting the phase actuator to its new/revised second setpoint value. These steps are repeated for all phase actuators from the set/group. When a phase actuator is set to a new/revised second setpoint value as part of this process, the new/revised second point value is the setpoint value used when other phase actuators from the set/group are being recharacterized.

Once all the phase actuators from the set/group of phase actuators have been recharacterized, the method comprises determining whether a threshold accuracy for the second desired operation has been reached. This can be done in multiple ways but may be performed as described above with respect to box 150.

If the desired accuracy threshold has not been reached, the method comprises performing another iteration of cycling through the set/group of phase actuators and determining revised setpoint values for the phase actuators from the set/group of phase actuators.

If the desired accuracy threshold has been reached, the method comprises storing the second setpoint values for each of the phase actuators in associated with the second desired operation. The method may also comprise storing the second target phases. This set of second setpoint values can be used to cause the reconfigurable photonic integrated circuit to implement the second desired operation.

Performing a second characterization for a second desired operation means the different crosstalk experienced by the phase actuators when implementing the second operation can also be compensated for. This ensures that both the first and second operations can be implemented accurately. In some examples, the above method may be repeated for any number of desired operations. This enables the reconfigurable photonic integrated circuit to be easily reprogrammed when in use. This also ensures that crosstalk is compensated for multiple different desired operations and setpoint values.

If setpoint values are determined to enable the implementation of multiple different desired operations, then the reconfigurable photonic integrated circuit can easily be dynamically reprogrammed during use. For example, the method may further comprise deciding to implement the first desired operation, setting the phase actuators to the first setpoint values and passing light states, squeezed light states or photonic qubits through the reconfigurable photonic integrated circuit. This will implement the first desired operation on the light states, squeezed light states or photonic qubits as the light states, squeezed light states or photonic qubits pass through the reconfigurable photonic integrated circuit. The method may then comprise determining the photonic circuit should be reprogrammed, in use, to implement the second desired operation. The method can then comprise setting the phase actuators to their second setpoint values and passing light states, squeezed light states or photonic qubits through the reconfigurable photonic integrated circuit. This will implement/apply the second desired operation on the light states, squeezed light states or photonics qubits. As such, the same reconfigurable photonic integrated circuit can easily be reprogrammed to implement multiple desired operations while in use. This ensures that the reconfigurable photonic integrated circuit is universally reconfigurable and can be used for implementing any desired operation in photonic routing and/or quantum computing.

Figure 2 is an illustrative flowchart summarizing the above method. In particular, as shown in step 210, the method begins with an uncharacterized reconfigurable photonic integrated circuit 215. The method comprises at step 220 characterizing each phase actuator individually while all other phase actuators are tuned off. This results in a 0-characterization such as the graph shown in 225. The method then comprises at step 230 implementing a set of phases at the phase actuators wherein the set of phases are determined to be a set of phases that implement a desired operation. The setpoint values of an adjustable parameter necessary to implement the set of phases can be determined from the characterizations found in step 220. As shown in 235 the implementing the phases will induce crosstalk which results in a parasitic phase shift on same of the phase actuators. For example, when the characterization takes the form *φ* = *a* + *bV*² + *cV³* + *dV⁴, φ* = *a* + *bI*² + *cI*³ + *dI*⁴*,* or *φ* = *a* + *bP* + *cP*² + *dP³* wherein *φ* is the phase of the actuator, V is the voltage, I is the current, P is the dissipated thermal power and a, b, c and d are constants then these parasitic phase shifts can alter the values of a, b, c and d compared to the 0-characterization. This means that even when the phase shifters are set to the setpoint value they will not implement the target phases. It is therefore desirable to compensate for crosstalk by determining revised setpoint values that take into account the crosstalk. This done in step 240 where at least some of the phase actuators of the plurality of phase actuators are recharacterized when all other phase actuators are set to their setpoint values. The results of this recharacterization can be used to determine a new setpoint value for each phase actuator of the at least some of the phase actuators. As shown at 245 the recharacterization of a phase actuator may differ from the original characterization. Once all of the at least some of the phase actuators have been recharacterized and a revised setpoint value found, a determination can be made as to whether the revised setpoint values implement the desired operation with a desired accuracy even in the presence of crosstalk. If the desired operation is not implemented with the desired accuracy, then steps 230 and 240 can be repeated at 250. In particular, each phase shifter can be set to its new setpoint value and the process of recharacterizing the phase actuators of the at least some of the phase actuators can be repeated. If the desired operation is implemented with the desired accuracy then the process can end and the determined setpoint values can be stored as the setpoint values that implement the desired operation.

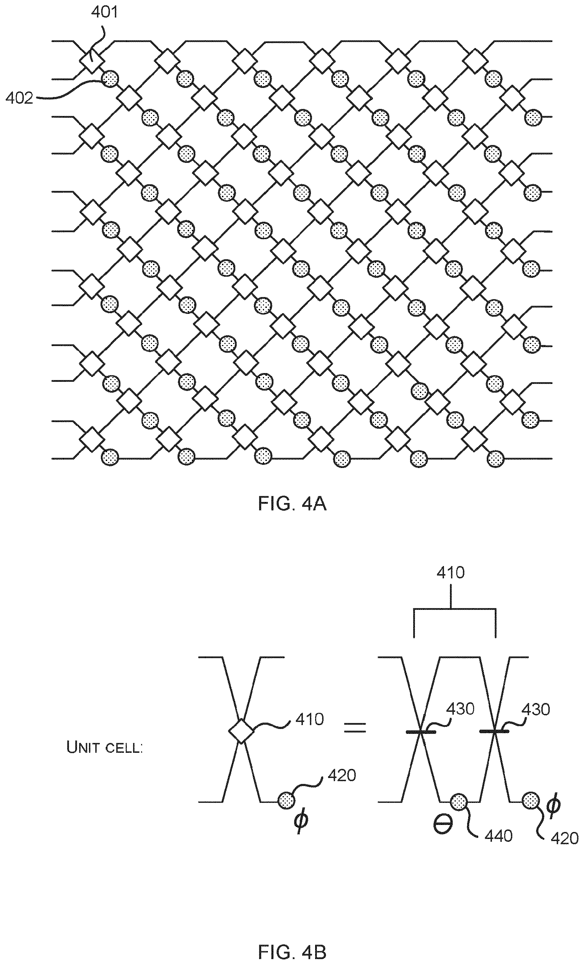

Figure 4A shows an example reconfigurable photonic integrated circuit in which the method described above can be used. The reconfigurable photonic integrated circuit comprises a plurality of tunable beam splitters 401 shown as diamonds/squares in Figure 4A and a plurality of phase shifters 402 shown as circles in Figure 4A, the lines connecting the phase shifters 402 and tunable beam splitters 401 represent waveguides. The phase shifters 402 can each be formed from a phase actuator such as the phase actuator described above. The tunable beam splitters 401 can each be formed as shown in Figure 4B. Figure 4B shows a tunable beam splitter 410 and a phase shifter 420. The tunable beam splitter 410 is formed of a Mach-Zehnder interferometer formed from two 50/50 directional couplers 430 (shown as lines in Figure 4B) with a phase shifter 440 in one arm or both arms of the Mach-Zehnder interferometer. While the phase shifter 440 is shown in the bottom arm of the Mach-Zehnder interferometer, the skilled person would understand the exact placement is not important and it could instead be in the upper arm of the Mach-Zehnder interferometer or a phase shifter 440 could be present in both arms of the Mach-Zehnder interferometer. Similarly, while the phase shifter 420 is shown in the bottom arm of the output of the Mach-Zehnder interferometer, the skilled person would understand the exact placement is not important and it could instead be in the top arm of the output of the Mach-Zehnder interferometer. The phase shifters that form the tunable beam splitters can in turn be formed from phase actuators. As such, the method described above with respect to general phase actuators can be used for a realistic implementation of a reconfigurable photonic integrated circuit such as that shown in Figure 4A.

In a detailed example, a method to iteratively characterize reconfigurable photonic integrated circuits that simultaneously compensates for crosstalk, for example thermal and electrical crosstalk and/or other forms of crosstalk to achieve the desired reconfigurability with high accuracy is provided. In the method, each phase actuator is characterized individually without any of the other phase actuators turned on. This is a characterization where no crosstalk is present and is called the "0-characterization". Next, a specific setting is implemented on each phase actuator using this 0-characterization. This is the "setpoint" of interest of the reconfigurable photonic integrated circuit. Due to the crosstalk induced by all phase actuators on all other phase actuators simultaneously, the implemented phases deviate from the target phases and the unitary transformation of the reconfigurable photonic integrated circuit will experience accuracy loss. This can be compensated for by the repeated characterizing of each phase actuator, while all the other phase actuators remain on their target setting. During this step, each phase actuator is returned to its target phase setting after the characterization. Due to the experienced crosstalk, the same phase can correspond with a new value of the setting, which is the crosstalk compensated setting. This process is repeated for all phase actuators for any number of iterations until the desired accuracy of the target setpoint is obtained. In this manner, the phase settings of the setpoint of interest are repeatedly refined by including the crosstalk present for this setpoint, since the repeated characterization of each phase actuator is performed subject to the crosstalk present on the target setpoint.

This characterization method has the additional benefit that implementing global settings close to the target setpoint all experience the same average crosstalk. Therefore, using the iterative characterization for setpoints close to those of the target setpoint automatically compensates for the crosstalk experienced, resulting in a high accuracy unitary transformation. If a new setpoint of interest deviates far from the setpoint on which the iterative characterization was performed, crosstalk can again result in accuracy loss. This can be compensated for by repeating the iterative characterization method at, or close at, the new setpoint to obtain new crosstalk compensated settings. This approach can be repeated for each setting of interest and allows obtaining a very high degree of universality for arbitrary unitary transformations with high accuracy on reconfigurable photonic integrated circuits.

In some examples some steps of the above method may be performed by a classical computing device/classical computer. For example, the steps of the above method that are calculations may be performed by the classical computing device. In addition, the classical computing device may be used to control the reconfigurable photonic integrated circuit.

In more detail, a classical computing device may be used to determine a target phase for each phase actuator given the desired operation. The classical computing device may also be used to determine setpoint values from a characterization of each phase actuator and to determine an accuracy to which the plurality of phase actuators implement the desired operation. The classical computing device may also be used to compare the accuracy to a threshold and then to determine whether the characterization of the phase actuators needs repeating. The steps of characterizing the phase actuators and setting the phase actuators to their setpoint values etc. comprise physical actions implemented on physical phase actuators of a physical reconfigurable photonic integrated circuit. As such, these actions are performed on the reconfigurable photonic integrated circuit itself. In some examples these steps may be performed using a classical computer to control the reconfigurable photonic integrated circuit by changing the settings of the reconfigurable photonic integrated circuit. Alternatively they may be performed by a user. In either case, these operations involve a physical interaction with a physical reconfigurable photonic integrated circuit that comprises physical phase actuators and changing the state of these physical phase actuators.

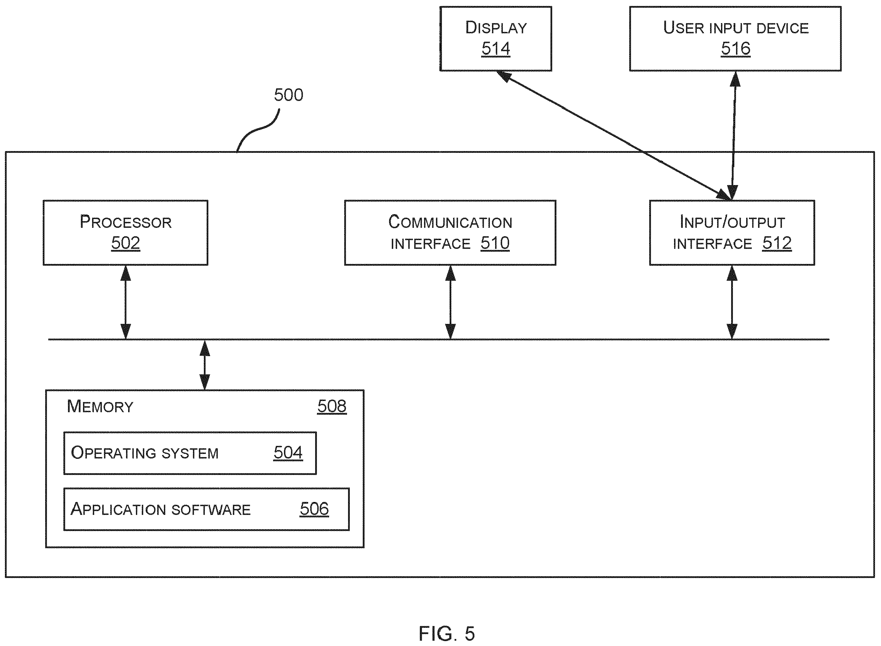

When a classical computing device is used to implement some parts of the method, the classical computing device may comprise the computing-based device shown in Figure 5. Figure 5 illustrates various components of an exemplary computing-based device 500 which may be implemented as any form of a computing and/or electronic device.

Computing-based device 500 comprises one or more processors 502 which may be microprocessors, controllers or any other suitable type of processors for processing computer executable instructions to control the operation of the device in order to implement the necessary steps of the above method. In some examples, where a system on a chip architecture is used, the processors 502 may include one or more fixed function blocks (also referred to as accelerators) which implement a part of the method in hardware (rather than software or firmware). Platform software comprising an operating system 504 or any other suitable platform software may be provided at the computing-based device to enable application software 506 to be executed on the device.

The computer executable instructions may be provided using any computer-readable media that is accessible by computing based device 500. Computer-readable media may include, for example, computer storage media such as memory 508 and communications media. Computer storage media, such as memory 508, includes volatile and non-volatile, removable and non-removable media implemented in any method or technology for storage of information such as computer readable instructions, data structures, program modules or other data. Computer storage media includes, but is not limited to, RAM, ROM, EPROM, EEPROM, flash memory or other memory technology, CD-ROM, digital versatile disks (DVD) or other optical storage, magnetic cassettes, magnetic tape, magnetic disk storage or other magnetic storage devices, or any other non-transmission medium that can be used to store information for access by a computing device. In contrast, communication media may embody computer readable instructions, data structures, program modules, or other data in a modulated data signal, such as a carrier wave, or other transport mechanism. As defined herein, computer storage media does not include communication media. Although the computer storage media (memory 508) is shown within the computing-based device 500 it will be appreciated that the storage may be distributed or located remotely and accessed via a network or other communication link (e.g. using communication interface 510).

The computing-based device 500 also comprises an input/output interface 512 arranged to output display information to a display device 514 which may be separate from or integral to the computing-based device 500. The display information may provide a graphical user interface. The input/output interface 512 is also arranged to receive and process input from one or more devices, such as a user input device 516 (e.g. a mouse or a keyboard). This user input may be used to control computer-based device 500. In an embodiment the display device 514 may also act as the user input device 516 if it is a touch sensitive display device. The input/output interface 512 may also output data to devices other than the display device, e.g. a locally connected printing device (not shown in Figure 5).

The term 'computer' is used herein to refer to any device with processing capability such that it can execute instructions. Those skilled in the art will realize that such processing capabilities are incorporated into many different devices and therefore the term 'computer' includes PCs, servers, mobile telephones, personal digital assistants and many other devices.

Those skilled in the art will realize that storage devices utilized to store program instructions can be distributed across a network. For example, a remote computer may store an example of the process described as software. A local or terminal computer may access the remote computer and download a part or all of the software to run the program. Alternatively, the local computer may download pieces of the software as needed, or execute some software instructions at the local terminal and some at the remote computer (or computer network). Those skilled in the art will also realize that by utilizing conventional techniques known to those skilled in the art that all, or a portion of the software instructions may be carried out by a dedicated circuit, such as a DSP, programmable logic array, or the like.

Any reference to 'an' item refers to one or more of those items. The term 'comprising' is used herein to mean including the method blocks or elements identified, but that such blocks or elements do not comprise an exclusive list and an apparatus may contain additional blocks or elements and a method may contain additional operations or elements. Furthermore, the blocks, elements and operations are themselves not impliedly closed.

The steps of the methods described herein may be carried out in any suitable order, or simultaneously where appropriate. The arrows between boxes in the figures show one example sequence of method steps but are not intended to exclude other sequences or the performance of multiple steps in parallel. Additionally, individual blocks may be deleted from any of the methods without departing from the spirit and scope of the subject matter described herein. Aspects of any of the examples described above may be combined with aspects of any of the other examples described to form further examples without losing the effect sought. Where elements of the figures are shown connected by arrows, it will be appreciated that these arrows show just one example flow of communications (including data and control messages) between elements. The flow between elements may be in either direction or in both directions.

Where the description has explicitly disclosed in isolation some individual features, any apparent combination of two or more such features is considered also to be disclosed, to the extent that such features or combinations are apparent and capable of being carried out based on the present specification as a whole in the light of the common general knowledge of a person skilled in the art, irrespective of whether such features or combinations of features solve any problems disclosed herein. In view of the foregoing description it will be evident to a person skilled in the art that various modifications may be made within the scope of the invention.

## Claims

1. A method of determining a first setpoint value for an adjustable parameter for each of a plurality of phase actuators in a reconfigurable photonic integrated circuit wherein setting each of the plurality of phase actuators to its respective first setpoint value causes the plurality of phase actuators to implement a first desired operation, the method comprising:
determining a first target phase for each phase actuator of the plurality of phase actuators such that when each phase actuator is set to its respective first target phase, the reconfigurable photonic integrated circuit implements the first desired operation;
characterizing each phase actuator when all other phase actuators of the plurality of phase actuators are turned off to obtain a characterization for each phase actuator wherein the characterization for each phase actuator comprises a relationship between the phase and the adjustable parameter for the phase actuator;
determining a first setpoint value for each phase actuator of the plurality of actuators based on the characterization of the phase actuator and the first target phase for the phase actuator;
setting each phase actuator to its first setpoint value;
adjusting the first setpoint value of at least some of the plurality of phase actuators to compensate for crosstalk by iteratively:
for each phase actuator of the at least some of the plurality of phase actuators:
recharacterizing the phase actuator when all other phase actuators of the plurality of phase actuators are set to their respective first setpoint values to obtain a revised characterization comprising a revised relationship between the phase and the adjustable parameter for the phase actuator;
determining a revised first setpoint value for the phase actuator based on the revised characterization and the first target phase for the phase actuator; and
setting the phase actuator to have the revised first setpoint value as its first setpoint value; and
after setting the at least some of the plurality of phase actuators to have a revised first setpoint value as their first setpoint value, determining an accuracy to which the plurality of phase actuators implement the first desired operation;
comparing the accuracy to a threshold;
in response to the accuracy not meeting the threshold repeating an iteration of adjusting the first setpoint value for at least some of the phase actuators; and
in response to the accuracy meeting a threshold storing the first setpoint values for each of the plurality of phase actuators in association with the first desired operation.

2. The method of claim 1 further comprising implementing the desired operation by setting each of the plurality of phase actuators to its first setpoint value.

3. The method of any previous claim further comprising determining second setpoint values wherein setting each of the plurality of phase actuators to its respective second setpoint value causes the plurality of phase actuators to implement a second desired operation, by:
determining a second target phase for each phase actuator such that when each phase actuator is set to its respective second target phase, the reconfigurable photonic integrated circuit implements the second desired operation;
obtaining a second characterization for each phase actuator when all other phase actuators of the plurality of phase actuators are turned off wherein the second characterization for each phase actuator comprises a relationship between the phase and the adjustable parameter for the phase actuator;
determining a second setpoint value for each phase actuator of the plurality of actuators based on the second characterization of the phase actuator and the second target phase for the phase actuator;
setting each phase actuator to its second setpoint value;
adjusting the second setpoint value of at least some of the plurality of phase actuators to compensate for crosstalk by iteratively:
for each phase actuator of the at least some of the plurality of phase actuators:
recharacterizing the phase actuator when all other phase actuators of the plurality of phase actuators are set to their respective second setpoint value to obtain a revised second characterization comprising a revised relationship between the phase and the adjustable parameter for the phase actuator;
determining a revised second setpoint value for the phase actuator based on the revised second characterization and the second target phase for the phase actuator; and
setting the phase actuator to have the revised second setpoint value as its second setpoint value; and
after setting the at least some of the plurality of phase actuators to have a revised second setpoint value as their second setpoint value, determining an accuracy to which the plurality of phase actuators implement the second desired operation;
comparing the accuracy to a threshold;
in response to the accuracy not meeting a threshold repeating an iteration of adjusting the second setpoint value for at least some of the phase actuators; and
in response to the accuracy meeting a threshold storing the second setpoint value for each of the plurality of phase actuators in association with the second desired operation.

4. The method of claim 3 further comprising:
determining whether the first desired operation and the second desired operation differ by more than a threshold amount;
responsive to determining the first desired operation and the second desired operation differ by more than a threshold amount performing the method of claim 3 to obtain the second setpoint values for the phase actuators;
responsive to determining the first desired operation and the second desired operation do not differ by more than a threshold amount using the revised characterizations of each phase actuator to obtain the second setpoint values for the phase actuators.

5. The method of claim 3 or claim 4 further comprising using the reconfigurable photonic integrated circuit to selectively implement the first and second desired operation by:
setting each of the plurality of phase actuators to its first setpoint value to implement the first desired operation; and
setting each of the plurality of phase actuators to its second setpoint value to implement the second desired operation.

6. The method of any previous claim wherein:
determining an accuracy to which the plurality of phase actuators implement the first desired operation comprises determining a difference between the first setpoint values to which the plurality of phase actuators were set at the start of the iteration and the revised first setpoint values to which the plurality of phase actuators are set at the end of an iteration;
comparing the accuracy to a threshold comprises comparing the difference to a threshold difference;
in response to the accuracy not meeting the threshold repeating an iteration of adjusting the first setpoint value for at least some of the phase actuators comprises in response to the difference being greater than the threshold difference repeating an iteration of adjusting the first setpoint value for at least some of the phase actuators; and
in response to the accuracy meeting a threshold storing the first setpoint values for each of the plurality of phase actuators in association with the first desired operation comprises in response to the difference not being greater than the threshold difference storing the first setpoint values for each of the plurality of phase actuators in association with the first desired operation.

7. The method of claims 1 to 6 wherein:
determining an accuracy to which the plurality of phase actuators implement the first desired operation comprises determining a fidelity of the first desired operation;
comparing the accuracy to a threshold comprises comparing the fidelity to a threshold fidelity;
in response to the accuracy not meeting the threshold repeating an iteration of adjusting the first setpoint value for at least some of the phase actuators comprises in response to the fidelity being less than the threshold fidelity repeating an iteration of adjusting the first setpoint value for at least some of the phase actuators; and
in response to the accuracy meeting a threshold storing the first setpoint values for each of the plurality of phase actuators in association with the first desired operation comprises in response to the fidelity not being less than the threshold fidelity storing the first setpoint values for each of the plurality of phase actuators in association with the first desired operation.

8. The method of any previous claim wherein recharacterizing at least some of the plurality of phase actuators comprises one of:
recharacterizing each phase actuator of the plurality of phase actuators; or
recharacterizing each phase actuator of the plurality of phase actuators that has a setpoint value above a threshold; or
recharacterizing each phase actuator of the plurality of phase actuators that is within a threshold distance of a phase actuator of the plurality of phase actuators that has a setpoint value above a threshold; or
recharacterizing each phase actuator of the plurality of phase actuators that has a setpoint value which differs from a setpoint value of a neighbouring phase actuator by more than a threshold difference.

9. The method of any previous claim wherein:
each setpoint value of the plurality of setpoint values comprises a setpoint voltage and the relationship between the phase and the adjustable parameter comprises a voltage-phase relationship;
the voltage-phase relationship for a phase actuator is given by *φ* = *a* + *bV*² + *cV*³ + *dV*⁴ wherein *φ* is the phase of the actuator, V is the voltage of the phase actuator and a, b, c and d are constants; and
characterizing the phase actuator comprises determining the constants a, b, c and d.

10. The method of claim 9 wherein determining a first/second setpoint voltage for each phase actuator of the plurality of phase actuators comprises using the relationship *φ* = *a* + *bV*² + *cV³* + *dV*⁴ and the values of constants a, b, c and d determined in the characterization to find the setpoint voltage from the target phase for the phase actuator.

11. The method of any of claims 1 to 8 wherein:
each setpoint value of the plurality of setpoint values comprises a setpoint current and the relationship between the phase and the adjustable parameter comprises a current-phase relationship;
the current-phase relationship for a phase actuator is given by *φ* = *a* + *bI*² + *cI*³ + *dI*⁴ wherein *φ* is the phase of the actuator, I is the current of the phase actuator and a, b, c and d are constants; and
characterizing the phase actuator comprises determining the constants a, b, c and d.

12. The method of any previous claim wherein each setpoint value of the plurality of setpoint values comprises a setpoint voltage and the relationship between the phase and the adjustable parameter comprises a voltage-phase relationship and characterizing a phase actuator comprises:
setting a voltage of the phase actuator to each of several interval voltages;
measuring a phase implemented by the phase actuator at each interval voltage; and
storing the characterization as the phase implemented by the actuator at each respective interval voltage.

13. The method of claim 12 wherein setting a voltage of the phase actuator to each of several intervals comprises setting the phase actuator to a set of voltages between 0V and 15V, and optionally, wherein each voltage in the set is separated from the others by 0.15V or 0.3V.

14. The method of any previous claim wherein determining a first/second target phase for each phase actuator such that when each phase actuator is set to its respective first/second target phase, the reconfigurable photonic integrated circuit implements the first/second desired operation comprises using a phase decomposition to determine the first/second target phases from the first/second desired operation.

15. The method of any previous claim wherein the reconfigurable photonic integrated circuit comprises:
a plurality of phase shifters wherein each phase shifter is formed from a phase actuator of the plurality of phase actuators; and
a plurality of tunable beam splitters wherein each tunable beam splitter is formed of a Mach-Zehnder interferometer with a phase shifter in one path or both paths of the Mach-Zehnder interferometer.
